# FASCICULE DE BREVET EUROPEEN

(11) **EP 3 079 258 B1**
(45) Date de publication et mention de la délivrance du brevet: **25.04.2018**
(21) Numéro de dépôt: 16159216.7
(22) Date de dépôt: 08.03.2016
(51) Int. Cl.: H03H 11/04, H03H 11/12, H03H 1/00, H02M 1/15, G05F 1/10, H02J 3/01, H02M 7/48, H03K 17/687, H02J 1/02, H02J 9/06

(54) **SYSTEME DE FILTRAGE ACTIF**
AKTIVES FILTERSYSTEM
ACTIVE FILTERING SYSTEM

(30) Priorité: 08.04.2015 FR 1552997
(43) Date de publication de la demande: 12.10.2016
(73) Titulaire: Schneider Electric Industries SAS, 92500 Rueil-Malmaison (FR)
(72) Inventeur: WANG, Miao-Xin, 38050 Grenoble (FR); DENTELLA, Alain, 38050 Grenoble (FR); GHOSH, Rajesh, 38050 Grenoble (FR)

(56) Documents cités:
- WO-A1-96/02969
- WO-A2-2007/090481
- DE-A1- 3 612 380
- GB-A- 2 248 981
- US-A- 5 999 422
- US-B1- 6 583 999

## Description

### Domaine technique de l'invention

La présente invention se rapporte à un système de filtrage actif. Ce système est destiné à être connecté à une source de tension continue située en amont.

### Etat de la technique

Des onduleurs monophasés sont couramment employés dans des convertisseurs de tension pour des applications de type alimentation sécurisée (UPS pour Uninterruptible Power Supply) ou dans le domaine du photovoltaïque.

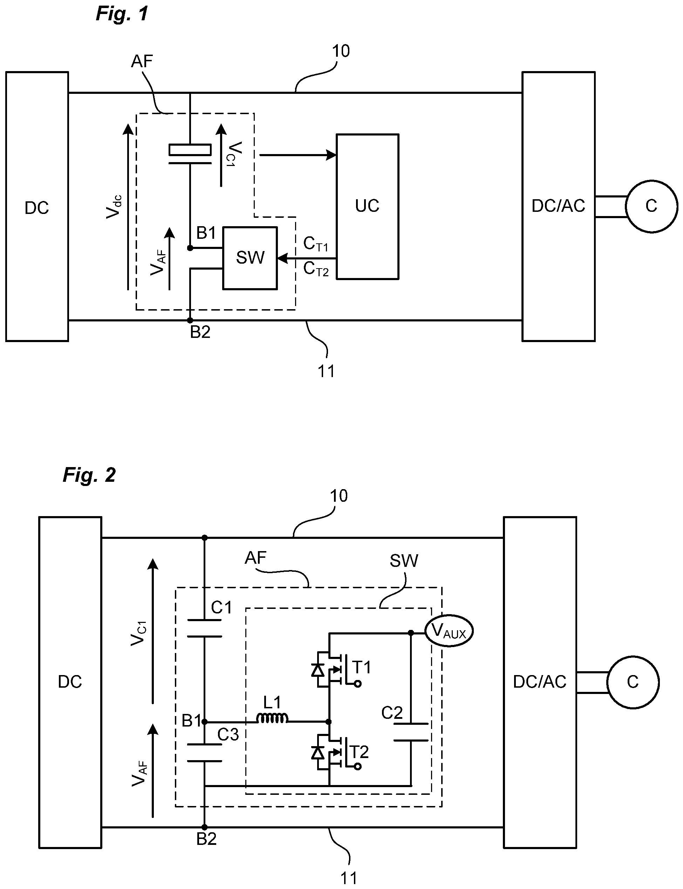

Dans ces applications, un bus continu d'alimentation comprenant deux lignes d'alimentation est connecté en amont à une source de tension continue, par exemple des panneaux photovoltaïques ou une batterie, et en aval à un onduleur commandé pour générer une tension variable à une charge électrique. Une solution de filtrage est employée pour contrôler les variations de tension présentes en entrée. Habituellement, pour éviter ces variations de tension, un ou plusieurs condensateurs de filtrage sont connectés à la première ligne d'alimentation et à la deuxième ligne d'alimentation du bus. La capacité totale des condensateurs doit être suffisante pour absorber les ondulations de la tension d'entrée. Les condensateurs sont souvent de type chimique et présentent un encombrement, un coût importants et une durée de vie limitée. Pour pallier ces inconvénients, des systèmes de filtrage actif ont été proposés. (voir US5999422A ou US6583999). La demande de brevet US2014/369090 décrit un système de filtrage actif destiné à être connecté à une source de tension continue située en amont et à un onduleur situé en aval et connecté à une charge. Le système est connecté en série sur le bus continu d'alimentation. Cette solution de l'état de la technique présente plusieurs inconvénients, parmi lesquels :
- la présence d'une ondulation de tension très importante à la sortie du bus continu d'alimentation (Vout1 sur la figure 1 du document),
- la nécessité d'employer dans le système de filtrage actif des transistors qui tiennent la tension du bus continu d'alimentation, rendant la solution coûteuse, génératrice de pertes élevées et complexe, les transistors du système devant être commandés avec des alimentations et des circuits de commande de grille isolés.
- le système étant connecté directement en série sur le bus continu d'alimentation, la nécessité de dimensionner la plupart des composants pour tenir le courant maximal de la charge, ce qui engendre des pertes élevées et augmente le coût global de la solution.

Le but de l'invention est de proposer un système de filtrage actif destiné à se connecter à un bus continu d'alimentation, qui soit particulièrement compact, d'un faible coût et qui génère des pertes limitées.

### Exposé de l'invention

Ce but est atteint par un système de filtrage actif agencé pour se connecter entre une première ligne d'alimentation et une deuxième ligne d'alimentation d'un bus continu, ledit bus étant agencé pour être connecté à une source de tension continue située en amont, ledit système comportant :
- un premier condensateur agencé pour se connecter d'une part à la première ligne d'alimentation du bus et d'autre part à la deuxième ligne d'alimentation du bus et aux bornes duquel est appliquée une tension comprenant une composante alternative,
- un ensemble de commutation commandé par des moyens de traitement pour générer une tension de compensation et comprenant une première borne connectée au premier condensateur et une deuxième borne destinée à se connecter à la deuxième ligne d'alimentation, lesdits moyens de traitement étant agencés pour déterminer des ordres de commande à appliquer à l'ensemble de commutation pour générer une tension de compensation aux bornes de l'ensemble de commutation, en mettant en oeuvre une boucle de régulation comprenant en entrée une valeur de référence de tension de compensation déterminée à partir de la composante alternative de la tension aux bornes du premier condensateur et une valeur mesurée de la tension de compensation aux bornes de l'ensemble de commutation.

Selon un premier mode de réalisation, l'ensemble de commutation comporte un premier transistor, un deuxième transistor connecté d'une part au premier transistor et d'autre part à sa deuxième borne, et une inductance connectée à sa première borne et à un point milieu de connexion situé entre les deux transistors et un deuxième condensateur connecté d'une part à la deuxième borne et d'autre part au premier transistor.

Selon un deuxième mode de réalisation, l'ensemble de commutation comporte :
- un premier transistor, un deuxième transistor connecté en série au premier transistor et une inductance connectée à sa première borne et à un point milieu de connexion situé entre les deux transistors,
- un deuxième condensateur connecté en parallèle des deux transistors,
- un troisième transistor et un quatrième transistor connectés en série et en parallèle du deuxième condensateur, le point milieu situé entre le troisième transistor et le quatrième transistor étant connecté à sa deuxième borne.

Selon une particularité, le système de l'invention comporte un troisième condensateur connecté à la première borne de l'ensemble de commutation et à la deuxième borne de l'ensemble de commutation.

### Brève description des figures

D'autres caractéristiques et avantages vont apparaître dans la description détaillée qui suit faite en regard des dessins annexés dans lesquels :
- la figure 1 représente, de manière schématique, l'architecture du système de filtrage actif de l'invention,
- la figure 2 représente un schéma électronique d'un exemple de réalisation du système de filtrage actif de l'invention,
- la figure 3 représente le synoptique de commande de l'ensemble de commutation employé dans le système de filtrage actif de l'invention,
- la figure 4 représente une variante de réalisation de l'ensemble de commutation employé dans le système de filtrage actif de l'invention.

### Description détaillée d'au moins un mode de réalisation

L'invention concerne un système de filtrage actif destiné à se connecter sur un bus continu d'alimentation, ledit bus comprenant une première ligne d'alimentation 10, par exemple à potentiel électrique positif et une deuxième ligne d'alimentation 11, par exemple à potentiel électrique négatif. Ledit bus continu d'alimentation est par exemple connecté à une source de tension continue (DC), par exemple un ou plusieurs panneaux photovoltaïques ou une batterie. La tension continue fournie par le bus est par exemple appliquée en entrée d'un onduleur (DC/AC) comportant des transistors commandés pour générer une tension variable à une charge électrique C.

Le système de filtrage actif AF de l'invention comporte :
- un premier condensateur C1 agencé pour se connecter d'une part à la première ligne d'alimentation 10 du bus et d'autre part à la deuxième ligne d'alimentation 11 du bus et aux bornes duquel est appliquée une tension V_{C1} comprenant une composante alternative,
- un ensemble de commutation SW agencé pour générer une tension de compensation V_{AF}, en opposition de la composante alternative de la tension aux bornes du premier condensateur C1, et comprenant une première borne B1 connectée au premier condensateur C1 et une deuxième borne B2 destinée à se connecter à la deuxième ligne d'alimentation 11.

L'ensemble de commutation SW doit être commandé de sorte que la capacité équivalente du système de filtrage actif soit la plus élevée possible. La capacité équivalente Ceq vaut en effet :
Ceq=C₁/(1-k) avec C₁ la capacité du premier condensateur C1 et k un gain de compensation.

A partir de cette relation, on comprend que pour une valeur de k proche de 1, inférieure à 1, mais non égale à 1, la capacité équivalente sera très élevée, permettant d'améliorer considérablement le filtrage à la fréquence d'ondulation de la tension d'entrée.

La figure 1 illustre le principe de fonctionnement du système de filtrage actif de l'invention. La commande de l'ensemble de commutation SW est réalisée de manière à générer une tension V_{AF} venant s'ajouter à la tension V_{C1} aux bornes du premier condensateur C1 en vue d'agir sur la tension Vdc du bus continu d'alimentation qui résulte de la somme des tensions V_{AF} et V_{C1}.

En fonction de la valeur de la tension V_{C1} aux bornes du premier condensateur C1, des moyens de traitement UC extraient les oscillations de cette tension puis détermine les signaux de commande C_{T1}, C_{T2}, par exemple de type MLI (Modulation à Largeur d'Impulsion), à appliquer à l'ensemble de commutation SW pour compenser ces oscillations.

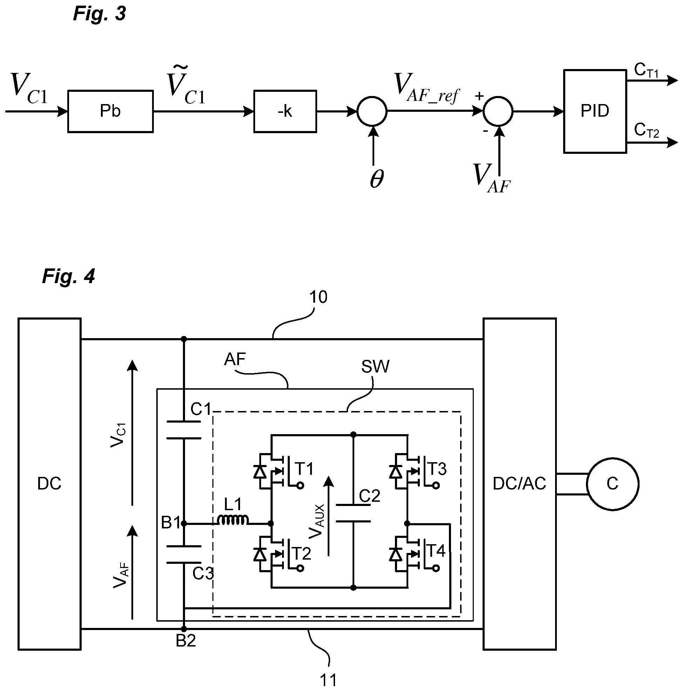

De manière plus précise, en référence à la figure 3, le principe de fonctionnement est le suivant :
- Dans une première étape, la tension V_{C1} mesurée par des moyens de mesure classiques est filtrée par les moyens de traitement UC à l'aide d'un filtre passe-bande Pb en vue de bloquer sa composante continue et ses ondulations à haute fréquence et de ne garder que sa composante alternative *Ṽ*_{C1}.
- Dans une deuxième étape, les moyens de traitement UC appliquent un gain à la composante alternative *Ṽ*_{*C*1} de la tension en vue d'ajuster le degré de compensation. Le gain vaut préférentiellement -k, k ayant une valeur proche de 1 mais toujours inférieure à 1 pour que la solution reste stable.
- Après application d'un offset *θ* à une troisième étape, les moyens de traitement obtiennent une valeur de référence V_{AF_ref} à atteindre pour la tension aux bornes de l'ensemble de commutation SW.
- Dans une quatrième étape, les moyens de traitement mettent en oeuvre une boucle de régulation dans laquelle est injectée la valeur de référence V_{AF_ref}. La boucle de régulation consiste à déterminer la différence entre la valeur de référence V_{AF_ref} à atteindre et une valeur V_{AF} de la tension mesurée par des moyens de mesure classique aux bornes de l'ensemble de commutation SW. La différence obtenue est injectée dans un régulateur, par exemple à action proportionnelle-intégrale-dérivé (PID). En sortie de la boucle de régulation, on obtient les ordres de commande C_{T1}, C_{T2} à appliquer à l'ensemble de commutation SW pour que la tension V_{AF} aux bornes de l'ensemble de commutation atteigne la valeur de référence V_{AF_ref}. Les ordres de commande C_{T1}, C_{T2} sont complémentaires, c'est-à-dire que les transistors T1 et T2 ne sont jamais à l'état fermé en même temps. Lorsque le transistor T1 est commandé à l'état fermé (le transistor T2 est alors à l'état ouvert), il conduit le courant et la tension V_{AF} augmente et tend vers la valeur de V_{AUX}. Lorsque le transistor T2 est commandé à l'état fermé (le transistor T1 est alors à l'état ouvert), il conduit le courant et la tension V_{AF} décroît pour tendre vers 0.

Avantageusement, l'ensemble de commutation comporte un premier transistor T1 et un deuxième transistor T2. Le deuxième transistor T2 est connecté à la deuxième borne B2 de l'ensemble de commutation SW et au premier transistor T1. Il comporte également une inductance L1 connectée d'une part à la première borne B1 de l'ensemble de commutation et au point milieu situé entre les deux transistors T1, T2. Il comporte également un condensateur C2, désigné deuxième condensateur, connecté au premier transistor T1 et à la deuxième borne B2 de l'ensemble de commutation SW. L'ensemble formé par les deux transistors T1, T2 et l'inductance L1 fonctionne comme un amplificateur de puissance qui permet de générer la tension V_{AF} destinée à compenser la composante alternative *Ṽ*_{*C*1} de la tension V_{C1} aux bornes du premier condensateur C1. Le deuxième condensateur C2 permet de créer un potentiel électrique V_{AUX} par rapport à la deuxième ligne d'alimentation L2 du bus continu pour alimenter l'amplificateur de puissance de l'ensemble de commutation SW. Le rôle du deuxième condensateur C2 est notamment d'encaisser la variation de puissance et de limiter la variation du potentiel Vaux.

Préférentiellement, l'amplificateur de puissance peut comporter un condensateur C3, désigné troisième condensateur qui permet, en collaboration avec l'inductance L1, de lisser la tension V_{AF} générée par la commutation des deux transistors T1, T2. Ce troisième condensateur C3 est connecté entre la première borne B1 et la deuxième borne B2 de l'ensemble de commutation SW.

Les transistors T1, T2 sont dimensionnés pour tenir la tension Vaux. Typiquement, la tension Vaux peut être de l'ordre de 1/20^{ème} de la tension Vdc du bus continu d'alimentation. L'ensemble de commutation formé par les transistors T1, T2 et l'inductance L1 sont dimensionnés pour supporter un courant de l'ordre de la valeur crête de la composante alternative du courant de charge.

La tension V_{AUX} à supporter étant faible, les transistors T1 et T2 peuvent être de type MOSFET basse tension, avec l'avantage de commuter à très haute fréquence (centaine de kHz, jusqu'à MHz) et d'avoir de très faible pertes en conduction (RDson très faible de l'ordre de milliOhm) et en commutation. L'inductance L1 pourra ainsi avoir une valeur faible.

La figure 4 représente une variante de réalisation de l'ensemble de commutation SW employée dans le système de filtrage actif AF de l'invention. Dans cette deuxième topologie, l'ensemble de commutation SW comporte deux transistors T3, T4 supplémentaires connectés en parallèle du deuxième condensateur C2. Par ailleurs, la deuxième borne B2 de l'ensemble de commutation SW n'est plus connectée au deuxième condensateur C2 et au deuxième transistor T2 mais au point milieu situé entre les deux transistors T3, T4. Comme dans la topologie précédente, le troisième condensateur C3 peut être prévu et connecté entre la première borne B1 et la deuxième borne B2. Cette deuxième topologie permet notamment de réduire la tension V_{AUX} appliquée sur le deuxième condensateur C2 et de pouvoir être utilisée pour générer une tension alternative, en remplacement du bus continu d'alimentation.

La solution de l'invention présente ainsi plusieurs avantages, parmi lesquels :
- Un encombrement limité,
- Des pertes réduites,
- Un coût modéré,
- Une mise en place aisée et un fonctionnement fiable.

## Revendications

1. Système de filtrage actif (AF) agencé pour se connecter entre une première ligne d'alimentation (10) et une deuxième ligne d'alimentation (11) d'un bus continu, ledit bus étant agencé pour être connecté à une source de tension continue située en amont, ledit système étant **caractérisé en ce qu'**il comporte :
- Un premier condensateur (C1) agencé pour se connecter d'une part à la première ligne d'alimentation du bus (10) et d'autre part à la deuxième ligne d'alimentation (11) du bus et aux bornes duquel est appliquée une tension (V_{C1}) comprenant une composante alternative (*Ṽ*_{*C*1}),
- Un ensemble de commutation (SW) commandé par des moyens de traitement (UC) pour générer une tension de compensation (V_{AF}) et comprenant une première borne (B1) connectée au premier condensateur (C1) et une deuxième borne (B2) destinée à se connecter à la deuxième ligne d'alimentation (11), lesdits moyens de traitement étant agencés pour déterminer des ordres de commande à appliquer à l'ensemble de commutation pour générer une tension de compensation (V_{AF}) aux bornes de l'ensemble de commutation (SW), en mettant en oeuvre une boucle de régulation comprenant en entrée une valeur de référence (V_{AF_ref}) de tension de compensation déterminée à partir de la composante alternative (*Ṽ*_{*C*1}) de la tension (Vc1) aux bornes du premier condensateur et une valeur (V_{AF}) mesurée de la tension de compensation aux bornes de l'ensemble de commutation.

2. Système selon la revendication 1, **caractérisé en ce que** l'ensemble de commutation (SW) comporte un premier transistor (T1), un deuxième transistor (T2) connecté d'une part au premier transistor (T1) et d'autre part à sa deuxième borne (B2), et une inductance (L1) connectée à sa première borne (B1) et à un point milieu de connexion situé entre les deux transistors et un deuxième condensateur (C2) connecté d'une part à la deuxième borne (B2) et d'autre part au premier transistor (T1).

3. Système selon la revendication 1, **caractérisé en ce que** l'ensemble de commutation (SW) comporte :
- un premier transistor (T1), un deuxième transistor (T2) connecté en série au premier transistor (T1) et une inductance (L1) connectée à sa première borne (B1) et à un point milieu de connexion situé entre les deux transistors,
- un deuxième condensateur (C2) connecté en parallèle des deux transistors (T1, T2),
- un troisième transistor (T3) et un quatrième transistor (T4) connectés en série et en parallèle du deuxième condensateur (C2), le point milieu situé entre le troisième transistor (T3) et le quatrième transistor (T4) étant connecté à sa deuxième borne (B2).

4. Système selon la revendication 2 ou 3, **caractérisé en ce qu'**il comporte un troisième condensateur (C3) connecté à la première borne (B1) de l'ensemble de commutation (SW) et à la deuxième borne (B2) de l'ensemble de commutation (SW).

## Patentansprüche

1. Aktives Filtersystem (AF), das ausgebildet ist, um zwischen einer ersten Speiseleitung (10) und einer zweiten Speiseleitung (11) eines Gleichstrombusses angeschlossen zu werden, wobei der Bus ausgebildet ist, um an eine Gleichspannungsquelle angeschlossen zu werden, die vorgelagert angeordnet ist, wobei das System **dadurch gekennzeichnet ist, dass** es aufweist:
- einen ersten Kondensator (C1), der ausgebildet ist, um einerseits an die erste Speiseleitung des Busses (10) und andererseits an die zweite Speiseleitung (11) des Busses angeschlossen zu werden, und an dessen Anschlussklemmen eine Spannung (V_{C1}) angelegt ist, die eine Wechselstrom-Komponente (*Ṽc*1) aufweist,
- eine Schaltanordnung (SW), die durch Verarbeitungsmittel (UC) gesteuert ist, um eine Kompensierungsspannung (V_{AF}) zu erzeugen, und die eine erste Anschlussklemme (B1), die an den ersten Kondensator (C1) angeschlossen ist, und eine zweite Anschlussklemme (B2) aufweist, die dazu bestimmt ist, um an die zweite Speiseleitung (11) angeschlossen zu werden, wobei die Verarbeitungsmittel angeordnet sind, um Steuerbefehle zu bestimmen, die an die Schaltanordnung anzuwenden sind, um eine Kompensierungsspannung (V_{AF}) an den Anschlussklemmen der Schaltanordnung (SW) durch Implementieren eines Regelkreises zu erzeugen, der am Eingang einen Referenzwert (V_{AF_ref}) der Kompensierungsspannung aufweist, der ausgehend von der Wechselstrom-Komponente (*Ṽc*1) der Spannung (Vc1) an den Anschlussklemmen des ersten Kondensators und einem gemessenen Wert (V_{AF}) der Kompensierungsspannung an den Anschlussklemmen der Schaltanordnung bestimmt ist.

2. System nach Anspruch 1, **dadurch gekennzeichnet, dass** die Schaltanordnung (SW) einen ersten Transistor (T1), einen zweiten Transistor (T2), der einerseits an den ersten Transistor (T1) und andererseits an ihre zweite Anschlussklemme (B2) angeschlossen ist, und eine Drosselspule (L1), die an ihre erste Anschlussklemme (B1) und an einen Mittelanschlusspunkt angeschlossen ist, der zwischen den zwei Transistoren angeordnet ist, und einen zweiten Kondensator (C2) aufweist, der einerseits an die zweite Anschlussklemme (B2) und andererseits an den ersten Transistor (T1) angeschlossen ist.

3. System nach Anspruch 1, **dadurch gekennzeichnet, dass** die Schaltanordnung (SW) aufweist:
- einen ersten Transistor (T1), einen zweiten Transistor (T2), der mit dem ersten Transistor (T1) in Reihe geschaltet ist, und eine Drosselspule (L1), die an ihre erste Anschlussklemme (B1) und an einen Mittelanschlusspunkt angeschlossen ist, der zwischen den zwei Transistoren angeordnet ist,
- einen zweiten Kondensator (C2), der mit den zwei Transistoren (T1, T2) parallel geschaltet ist,
- einen dritten Transistor (T3) und einen vierten Transistor (T4), die in Reihe und parallel mit dem zweiten Kondensator (C2) geschaltet sind, wobei der Mittelpunkt, der zwischen dem dritten Transistor (T3) und dem vierten Transistor (T4) angeordnet ist, an ihre zweite Anschlussklemme (B2) angeschlossen ist.

4. System nach Anspruch 2 oder 3, **dadurch gekennzeichnet, dass** es einen dritten Kondensator (C3) aufweist, der an die erste Anschlussklemme (B1) der Schaltanordnung (SW) und an die zweite Anschlussklemme (B2) der Schaltanordnung (SW) angeschlossen ist.

## Claims

1. Active filtering system (AF) arranged for being connected between a first power supply line (10) and a second power supply line (11) of a DC bus, said bus being arranged for being connected to a DC voltage source located upstream, said system being **characterized in that** it comprises:
- A first capacitor (C1) arranged for being connected both to the first power supply line (10) of the bus and to the second power supply line (11) of the bus and to the terminals whereof a voltage (V_{C1}) is applied including an AC component (*Ṽ*_{*C*1}),
- A switching assembly (SW) controlled by processing means (UC) for generating a compensation voltage (V_{AF}) and comprising a first terminal (B1) connected to the first capacitor (C1) and a second terminal (B2) intended to be connected to the second supply line (11), said processing means being arranged for determining control commands to be applied to the switching assembly to generate a compensation voltage (V_{AF}) across the terminals of the switching assembly (SW), by implementing a regulating loop comprising as input a reference value (V_{AF_ref}) of compensation voltage determined on the basis of the AC component (*Ṽ*_{*C*1}) of the voltage (Vc1) across the terminals of the first capacitor and a measured value (V_{AF}) of the compensation voltage across the terminals of the switching assembly.

2. System according to Claim 1, **characterized in that** the switching assembly (SW) comprises a first transistor (T1), a second transistor (T2) connected both to the first transistor (T1) and to the second terminal (B2) thereof, and an inductor (L1) connected to the first terminal (B1) thereof and to a connection midpoint located between the two transistors and a second capacitor (C2) connected both to the second terminal (B2) and to the first transistor (T1).

3. System according to Claim 1, **characterized in that** the switching assembly (SW) comprises:
- a first transistor (T1), a second transistor (T2) connected in series to the first transistor (T1) and an inductor (L1) connected to the first terminal (B1) thereof and to a connection midpoint located between the two transistors,
- a second capacitor (C2) connected in parallel with the two transistors (T1, T2),
- a third transistor (T3) and a fourth transistor (T4) connected in series and in parallel with the second capacitor (C2), the midpoint located between the third transistor (T3) and the fourth transistor (T4) being connected to the second terminal (B2) thereof.

4. System according to Claim 2 or 3, **characterized in that** it comprises a third capacitor (C3) connected to the first terminal (B1) of the switching assembly (SW) and to the second terminal (B2) of the switching assembly (SW).
